# EUROPEAN PATENT APPLICATION

(11) **EP 4 791 178 A2**
(43) Date of publication of application: **12.08.2026**
(21) Application number: 26155130.3
(22) Date of filing: 29.01.2026
(51) Int. Cl.: H10W 44/20, H10W 44/00, H10W 20/40, H10W 70/09

(54) **OFF-CHIP PASSIVE COMPONENTS FOR RADIO FREQUENCY INTEGRATED CIRCUITS**

(30) Priority: 31.01.2025 US 202563752610 P
(71) Applicant: Space Exploration Technologies Corp., Hawthorne, California 90250 (US)
(72) Inventor: AGAH, Amir, Hawthorne, 90250 (US); SOTNICK, Elliot, Hawthorne, 90250 (US); MA, Haien, Hawthorne, 90250 (US)
(74) Representative: Mewburn Ellis LLP

(57) **Abstract**

Systems and techniques are provided for providing off-chip passive components for radio frequency (RF) integrated circuits. For example, a process can include obtaining an RFIC, wherein the RFIC comprises a semiconductor substrate (502), a metal layer (506) disposed on a surface of the semiconductor substrate, and a passivation layer (504) disposed on the surface of the semiconductor substrate and configured to prevent physical contact with the semiconductor substrate, wherein the passivation layer includes an exposed area. The process further includes adding an additional metal layer (510) to the RFIC, wherein the additional metal layer contacts an exposed portion of the metal layer corresponding to the exposed area of the passivation layer, wherein the additional metal layer includes one or more passive electrical components (532).

## Description

### CROSS-REFERENCE TO RELATED APPLICATIONS

The present application claims the benefit of, and priority to, U.S. Provisional Patent Application No. 63/752,610, filed January 31, 2025, entitled "OFF-CHIP PASSIVE COMPONENTS FOR RADIO FREQUENCY INTEGRATED CIRCUITS", the contents of which are hereby incorporated by reference in their entirety.

### TECHNICAL FIELD

The present disclosure generally relates to wireless communications and, more specifically, systems and techniques for providing off-chip passive components for radio frequency (RF) integrated circuits.

### BACKGROUND

Phased array antennas are used in a variety of wireless communication systems such as satellite and cellular communication systems, radio detection and ranging (RADAR), and other applications. The phased array antennas can include a number of antenna elements arranged to behave as a larger directional antenna. Moreover, a phased array antenna can be used to increase an overall directivity and gain, steer the angle of array for greater gain and directivity, perform interference cancellation from one or more directions, determine the direction of arrival of received signals, and improve a signal to interference ratio, among other things. Advantageously, a phased array antenna can be configured to implement beamforming techniques to transmit and/or receive signals in a preferred direction without physically repositioning or reorientation.

It would be advantageous to configure phased array antennas to support an increased number of simultaneous data beams for transmitting and/or receiving signals. Likewise, it would be advantageous to configure phased array antennas and associated circuitry having reduced weight, reduced size, lower manufacturing cost, and/or lower power requirements. Accordingly, embodiments of the present disclosure are directed to these and other improvements in phase array antenna systems or portions thereof.

### SUMMARY

This summary is provided to introduce a selection of concepts in a simplified form that are further described below in the Detailed Description. This summary is not intended to identify key features of the claimed subject matter, nor is it intended to be used as an aid in determining the scope of the claimed subject matter.

In accordance with one embodiment of the present disclosure, an apparatus is provided. The apparatus includes: an integrated circuit comprising a semiconductor substrate, a metal layer disposed on a surface of the semiconductor substrate, and a passivation layer disposed on the surface of the semiconductor substrate and configured to prevent physical contact with the semiconductor substrate, wherein the passivation layer includes an exposed area. The apparatus includes an interposer comprising an additional metal layer, wherein the additional metal layer contacts an exposed portion of the metal layer corresponding to the exposed area of the passivation layer, wherein the additional metal layer includes one or more passive electrical components

In accordance with another embodiment of the present disclosure, a method for providing off-chip passive components for radio frequency (RF integrated circuits) RFICs is provided. The method includes: obtaining an RFIC, wherein the RFIC comprises: a semiconductor substrate, a metal layer disposed on a surface of the semiconductor substrate, and a passivation layer disposed on the surface of the semiconductor substrate and configured to prevent physical contact with the semiconductor substrate, wherein the passivation layer includes an exposed area. The method includes adding an additional metal layer to the RFIC, wherein the additional metal layer contacts an exposed portion of the metal layer corresponding to the exposed area of the passivation layer, wherein the additional metal layer includes one or more passive electrical components.

This summary is not intended to identify key or essential features of the claimed subject matter, nor is it intended to be used in isolation to determine the scope of the claimed subject matter. The subject matter should be understood by reference to appropriate portions of the entire specification of this patent, any or all drawings, and each claim.

The foregoing, together with other features and embodiments, will become more apparent upon referring to the following specification, claims, and accompanying drawings.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1A is a simplified diagram illustrating an example wireless communication system, in accordance with some examples of the present disclosure;
FIG. 1B is a simplified diagram illustrating an example of communication in a satellite communication system, in accordance with some examples of the present disclosure;
FIG. 2A and FIG. 2B are isometric top and bottom views depicting an exemplary antenna apparatus, in accordance with some examples of the present disclosure;
FIG. 3A is an isometric exploded view depicting an exemplary antenna apparatus including the housing and the antenna stack assembly, in accordance with some examples of the present disclosure;
FIG. 3B is a cross-sectional view of an antenna stack assembly of an antenna apparatus, in accordance with some examples of the present disclosure;
FIG. 4A is a diagram illustrating an example illustration of a top view of an antenna lattice, in accordance with some examples of the present disclosure;
FIG. 4B is a diagram illustrating an example phased array antenna system, in accordance with some examples of the present disclosure;
FIG. 4C is a diagram illustrating an additional example phased array antenna system, in accordance with some examples of the present disclosure;
FIG. 4D shows a schematic illustrating an example main lobe and side lobes emanating from an antenna array of an example phased array antenna system, in accordance with some examples of the present disclosure;
FIG. 5A through FIG. 5D are diagrams illustrating cross-sections of material stackups for providing electrical connections and/or passive components utilizing a redistribution layer, in accordance with some examples of the present disclosure;
FIG. 6A and FIG. 6B are diagrams illustrating overhead views of example electrical connections and passive components utilizing a redistribution layer, in accordance with some examples of the present disclosure;
FIG. 7A through FIG. 7C are simplified schematic diagrams illustrating removal of RF signal routing passive components from a radio frequency integrated circuit (RFIC) using a redistribution layer, in accordance with some examples of the present disclosure;
FIG. 8 is a flow diagram illustrating a process for providing off-chip passive components for RFICs.

### DETAILED DESCRIPTION

Certain aspects and embodiments of this disclosure are provided below. Some of these aspects and embodiments may be applied independently and some of them may be applied in combination as would be apparent to those of skill in the art. In the following description, for the purposes of explanation, specific details are set forth in order to provide a thorough understanding of embodiments of the application. However, it will be apparent that various embodiments may be practiced without these specific details. The figures and description are not intended to be restrictive.

The ensuing description provides example embodiments only, and is not intended to limit the scope, applicability, or configuration of the disclosure. Rather, the ensuing description of the exemplary embodiments will provide those skilled in the art with an enabling description for implementing an exemplary embodiment. It should be understood that various changes may be made in the function and arrangement of elements without departing from the spirit and scope of the application as set forth in the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments, and, in some embodiments, it may not be included or may be combined with other features.

References in the specification to "one embodiment," "an embodiment," "an illustrative embodiment," etc., indicate that the embodiment described may include a particular feature, structure, or characteristic, but every embodiment may or may not necessarily include that particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. Language such as "top", "bottom", "upper", "lower", "vertical", "horizontal", "lateral", in the present disclosure is meant to provide orientation for the reader with reference to the drawings and is not intended to be the required orientation of the components or to impart orientation limitations into the claims.

The phrase "coupled to" refers to any component that is physically connected to another component either directly or indirectly, and/or any component that is in communication with another component (e.g., connected to the other component over a wired or wireless connection, and/or other suitable communication interface) either directly or indirectly.

In some aspects, systems, apparatuses, processes (also referred to as methods), and computer-readable media (collectively referred to herein as "systems and techniques") are described herein for off-chip impedance matching for RF signal distribution. Various aspects of the techniques described herein will be discussed below with respect to the figures.

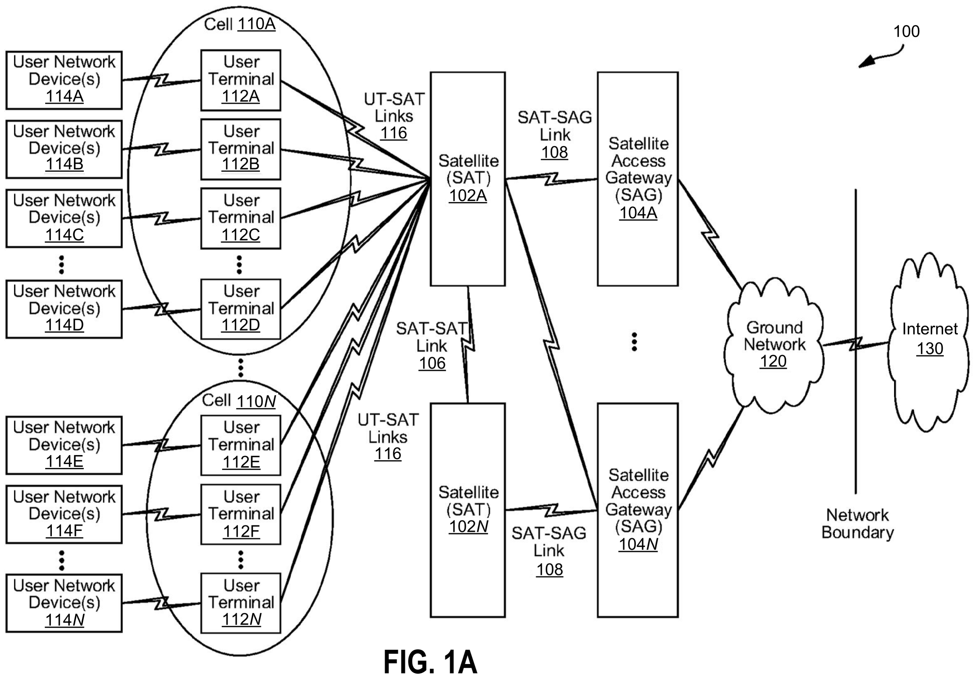

FIG. 1A is a block diagram illustrating an example wireless communication system 100, in accordance with some examples of the present disclosure. In this example, the wireless communication system 100 is a satellite-based communication system and includes one or more satellites (SATs) 102A-102*N* (collectively "102"), one or more satellite access gateways (SAGs) 104A-104N (collectively "104"), user terminals (UTs) 112A-112*N* (collectively "112"), user network devices 114A-114*N* (collectively "114"), and a ground network 120 in communication with a network 130, such as the Internet.

The SATs 102 can include orbital communications satellites capable of communicating with other wireless devices or networks (e.g., 104, 112, 114, 120, 130) via radio telecommunications signals. The SATs 102 can provide communication channels, such as radio frequency (RF) links (e.g., 106, 108, 116), between the SATs 102 and other wireless devices located at different locations on Earth and/or in orbit. In some examples, the SATs 102 can establish communication channels for Internet, radio, television, telephone, radio, military, and/or other applications.

The user terminals 112 can include any electronic devices and/or physical equipment that support RF communications to and from the SATs 102. The SAGs 104 can include gateways or earth stations that support RF communications to and from the SATs 102. The user terminals 112 and the SAGs 104 can include antennas for wirelessly communicating with the SATs 102. The user terminals 112 and the SAGs 104 can also include satellite modems for modulating and demodulating radio waves used to communicate with the SATs 102. In some examples, the user terminals 112 and/or the SAGs 104 can include one or more server computers, routers, ground receivers, earth stations, user equipment, antenna systems, communication nodes, base stations, access points, and/or any other suitable device or equipment. In some cases, the user terminals 112 and/or the SAGs 104 can perform phased-array beamforming and digital processing to support highly directive, steered antenna beams that track the SATs 102. Moreover, the user terminals 112 and/or the SAGs 104 can use one or more frequency bands to communicate with the SATs 102, such as the Ku and/or Ka frequency bands.

The user terminals 112 can be used to connect the user network devices 114 to the SATs 102 and ultimately the Internet 130. The SAGs 104 can be used to connect the ground network 120 and the Internet 130 to the SATs 102. For example, the SAGs 104 can relay communications from the ground network 120 and/or the Internet 130 to the SATs 102, and communications from the SATs 102 (e.g., communications originating from the user network devices 114, the user terminals 112, or the SATs 102) to the ground network 120 and/or the Internet 130.

The user network devices 114 can include any electronic devices with networking capabilities and/or any combination of electronic devices such as a computer network. For example, the user network devices 114 can include routers, network modems, switches, access points, smart phones, laptop computers, servers, tablet computers, set-top boxes, Internet-of-Things (IoT) devices, smart wearable devices (e.g., head-mounted displays (HMDs), smart watches, etc.), gaming consoles, smart televisions, media streaming devices, autonomous vehicles or devices, user networks, etc. The ground network 120 can include one or more networks and/or data centers. For example, the ground network 120 can include a public cloud, a private cloud, a hybrid cloud, an enterprise network, a service provider network, an on-premises network, and/or any other network.

In some cases, the SATs 102 can establish communication links between the SATs 102 and the user terminals 112. For example, SAT 102A can establish communication links 116 between the SAT 102A and the user terminals 112A-112D and/or 112E-112N. The communication links 116 can provide communication channels between the SAT 102A and the user terminals 112A-112D and/or 112E-112N. In some examples, the user terminals 112 can be interconnected (e.g., via wired and/or wireless connections) with the user network devices 114. Thus, the communication links between the SATs 102 and the user terminals 112 can enable communications between the user network devices 114 and the SATs 102. In some examples, each of the SATs 102A-N can serve user terminals 112 distributed across and/or located within one or more cells 110A-1 10*N* (collectively "110"). The cells 110 can represent geographic areas served and/or covered by the SATs 102. For example, each cell can represent an area corresponding to the satellite footprint of radio beams propagated by a SAT. In some cases, a SAT can cover a single cell. In other cases, a SAT can cover multiple cells. In some examples, a plurality of SATs 102 can be in operation simultaneously at any point in time (also referred to as a satellite constellation). Moreover, different SATs can serve different cells and sets of user terminals.

The SATs 102 can also establish communication links 106 with each other to support inter-satellite communications. Moreover, the SATs 102 can establish communication links 108 with the SAGs 104. In some cases, the communication links between the SATs 102 and the user terminals 112 and the communication links between the SATs 102 and the SAGs 104 can allow the SAGs 104 and the user terminals 112 to establish a communication channel between the user network devices 114, the ground network 120 and ultimately the Internet 130. For example, the user terminals 112A-D and/or 112E-N can connect the user network devices 114A-114D and/or 114E-114N to the SAT 102A through the communication links 116 between the SAT 102A and the user terminals 112A-D and/or 112E-N. The SAG 104A can connect the SAT 102A to the ground network 120, which can connect the SAGs 104A-N to the Internet 130. Thus, the communication links 108 and 116, the SAT 102A, the SAG 104A, the user terminals 112A-D and/or 112E-N and the ground network 120 can allow the user network devices 114A-114D and/or *114E-114N* to connect to the Internet 130.

In some examples, a user can initiate an Internet connection and/or communication through a user network device from the user network devices 114. The user network device can have a network connection to a user terminal from the user terminals 112, which it can use to establish an uplink (UL) pathway to the Internet 130. The user terminal can wirelessly communicate with a particular SAT from the SATs 102, and the particular SAT can wirelessly communicate with a particular SAG from the SAGs 104. The particular SAG can be in communication (e.g., wired and/or wireless) with the ground network 120 and, by extension, the Internet 130. Thus, the particular SAG can enable the Internet connection and/or communication from the user network device to the ground network 120 and, by extension, the Internet 130.

In some cases, the particular SAT and SAG can be selected based on signal strength, line-of-sight, and the like. If a SAG is not immediately available to receive communications from the particular SAT, the particular SAG can be configured to communicate with another SAT. The second SAT can in turn continue the communication pathway to a particular SAG. Once data from the Internet 130 is obtained for the user network device, the communication pathway can be reversed using the same or different SAT and/or SAG as used in the UL pathway.

In some examples, the communication links (e.g., 106, 108, and 116) in the wireless communication system 100 can operate using orthogonal frequency division multiple access (OFDMA) via time domain and frequency domain multiplexing. OFDMA, also known as multicarrier modulation, transmits data over a bank of orthogonal subcarriers harmonically related by the fundamental carrier frequency. Moreover, in some cases, for computational efficiency, fast Fourier transforms (FFT) and inverse FFT can be used for modulation and demodulation.

While the wireless communication system 100 is shown to include certain elements and components, one of ordinary skill will appreciate that the wireless communication system 100 can include more or fewer elements and components than those shown in FIG. 1A. For example, the wireless communication system 100 can include, in some instances, networks, cellular towers, communication hops or pathways, network equipment, and/or other electronic devices that are not shown in FIG. 1A.

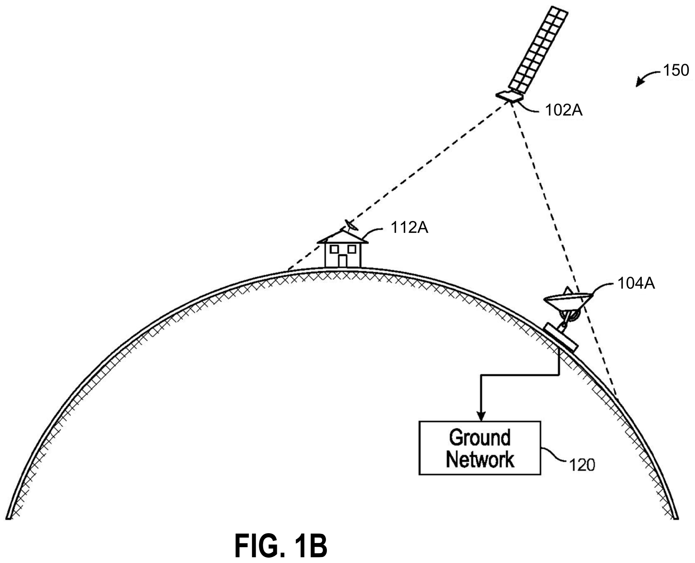

FIG. 1B is a diagram illustrating an example of an antenna and satellite communication system 100 in accordance with some examples of the present disclosure. As shown in FIG. 1B, an Earth-based UT 112A is installed at a location directly or indirectly on the Earth's surface such as a house, building, tower, vehicle, or another location where it is desired to obtain communication access via a network of satellites.

A communication path may be established between the UT 112A and SAT 102A. In the illustrated example, the SAT 102A, in turn, establishes a communication path with a SAG 104A. In another example, the SAT 102A may establish a communication path with another satellite prior to communication with SAG 104A. The SAG 104A may be physically connected via fiber optic, Ethernet, or another physical connection to a ground network 120. The ground network 120 may be any type of network, including the Internet. While one satellite is illustrated, communication may be with and between a constellation of satellites.

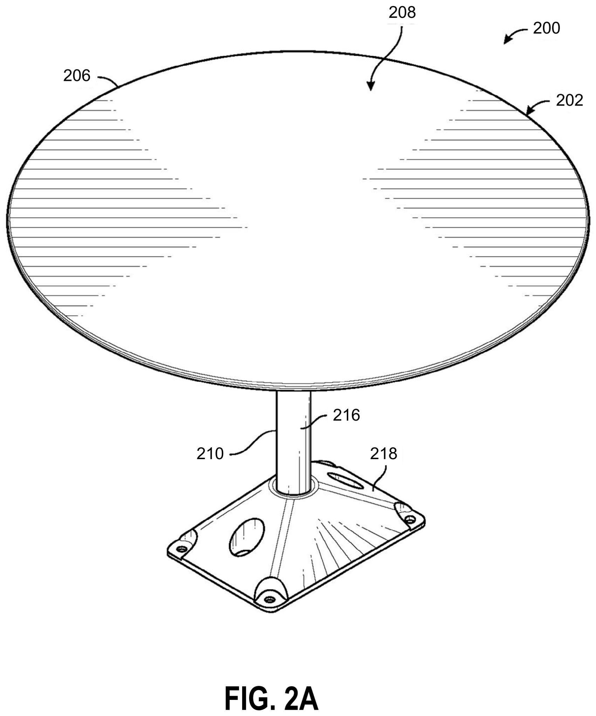

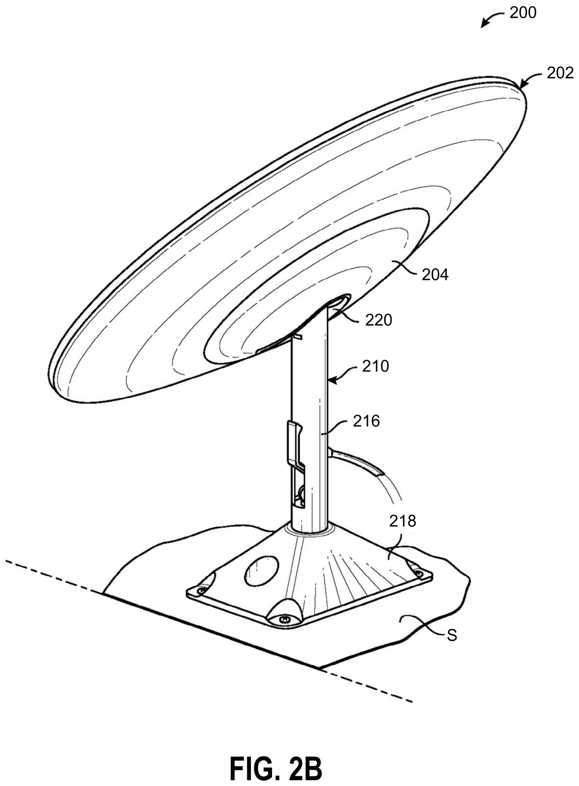

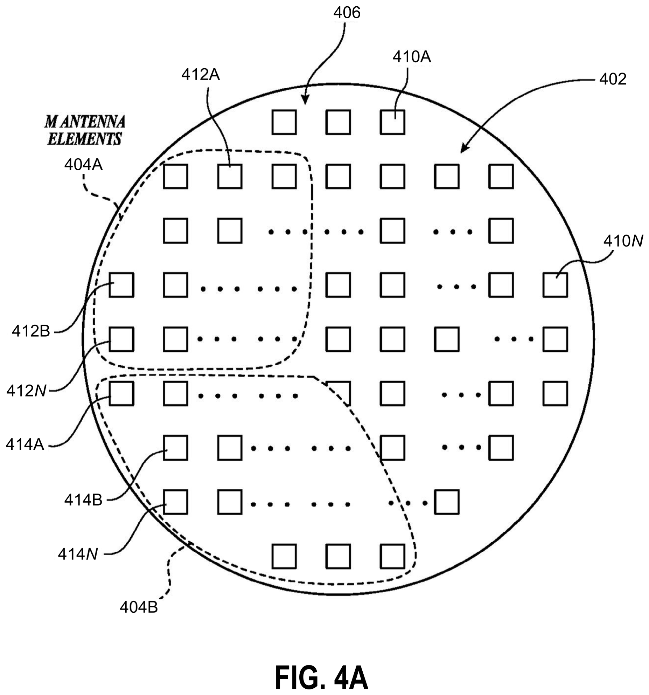

In some examples, the UT 112A may include an antenna system disposed in an antenna apparatus 200, for example, as illustrated in FIG. 2A and FIG. 2B, designed for sending and/or receiving radio frequency signals to and/or from a satellite or a constellation of satellites. FIG. 2A illustrates an example top view of the antenna apparatus 200. The antenna apparatus 200 may include an antenna aperture (e.g., antenna aperture 402 of FIG. 4A) defining an area for transmitting and receiving signals, such as a phased array antenna system or another antenna system. The antenna apparatus 200 may include a top enclosure 208 that couples to a radome portion 206 to define a housing 202. The antenna apparatus 200 can also include a mounting system 210 having a leg 216 and a base 218.

FIG. 2B illustrates a perspective view of an underside of the antenna apparatus 200. As shown, the antenna apparatus 200 may include a lower enclosure 204 that couples to the radome portion 206 to define the housing 202. In the illustrated example, the mounting system 210 includes a leg 216 and a base 218. The base 218 may be securable to a surface S and configured to receive a bottom portion of the leg 216. A tilting mechanism 220 (details not shown) disposed within the lower enclosure 204 permits a degree of tilting to point the face of the radome portion 206 at a variety of angles for optimized communication and for rain and snow run-off.

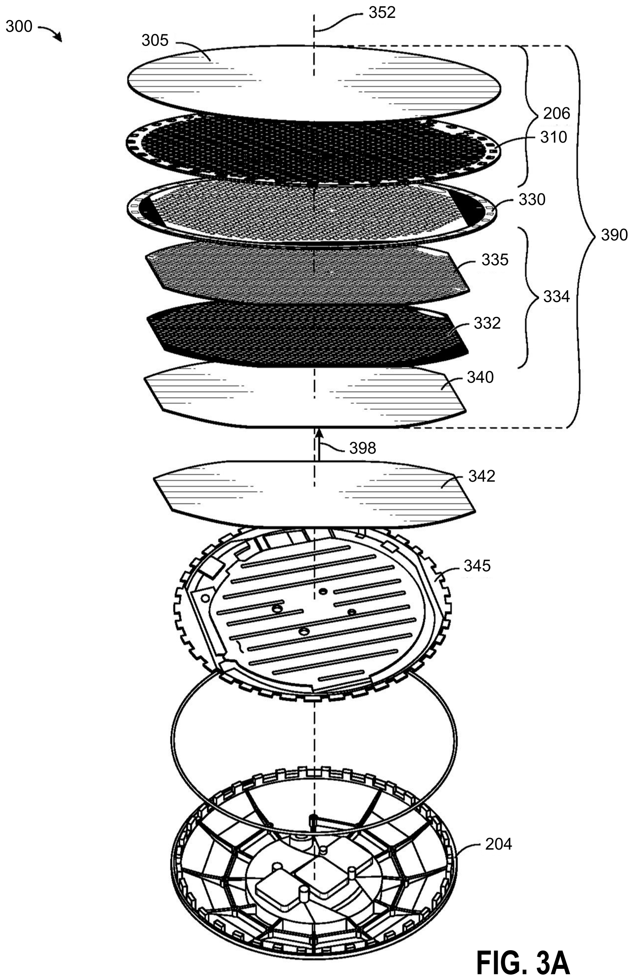

Referring to FIG. 3A, an antenna stack assembly 300 can include a plurality of antenna components, which can include a printed circuit board (PCB) assembly 342 configured to couple to other electrical components disposed within the housing assembly 202 (including lower enclosure 204 and radome assembly 206). In the illustrated example, the antenna stack assembly 300 includes a phased array antenna assembly including a plurality of individual antenna elements configured in an array. The components of the phased array antenna assembly 334 may be mechanically and electrically supported by the PCB assembly 342.

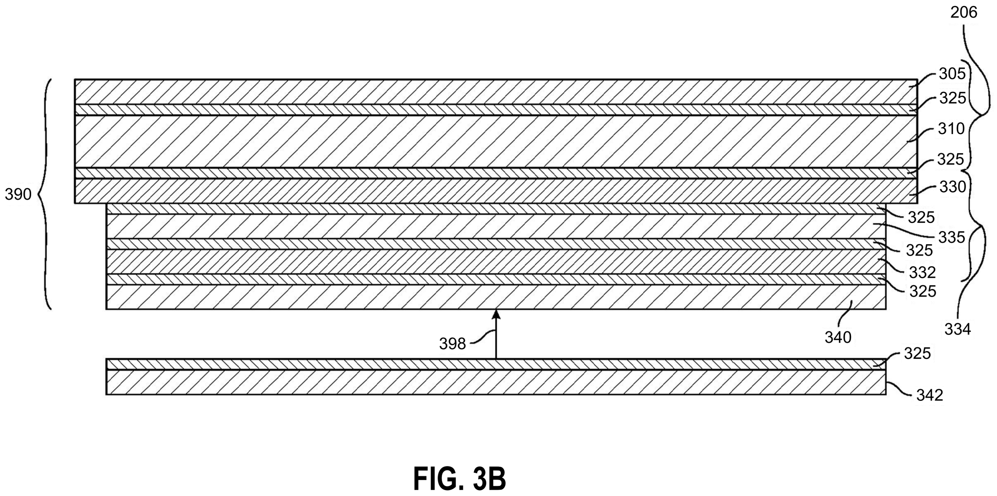

In the illustrated example of FIG. 3A and FIG. 3B, the layers in the antenna stack assembly 300 layup include a radome assembly 206 (including radome 305 and radome spacer 310), a phased array patch antenna assembly 334 (including upper patch layer 330, lower patch layer 332, and antenna spacer 335 in between), a dielectric layer 340, and PCB assembly 342, as will be described in greater detail below. As seen in FIG. 3B, the layers may include adhesive coupling 325 between adjacent layers. The layers of the antenna stack assembly 300 may be aligned relative to an axis 352.

The phased array patch antenna assembly 334 may be separate from but mechanically and electrically supported by a printed circuit board (PCB) assembly 342. The PCB assembly 342 is generally configured to connect electronic components using conductive tracks, pads and other features etched from one or more sheet layers of copper laminated onto and/or between sheet layers of a non-conductive substrate. The PCB assembly 342 may be a single or multilayer assembly with various layers copper, laminate, substrates and may have various circuits formed therein.

Referring to FIG. 3B, the adhesive layer stack 390, which is a stack of layers in the antenna stack assembly 300 having adhesive 325 therebetween, including the following structural layers: radome 305, radome spacer 310, upper patch antenna layer 330, antenna spacer 335, lower patch antenna layer 332, and dielectric spacer 340. In addition to the adhesive layer stack 390, in some embodiments, the PCB assembly may also be adhered by adhesive bonding and pressed with the adhesive layer stack 390 as shown by arrow 398 in FIGURES 3A and 3B.

### PHASED ARRAY ANTENNA WITH SERIALLY FED FRONTEND NETWORKS

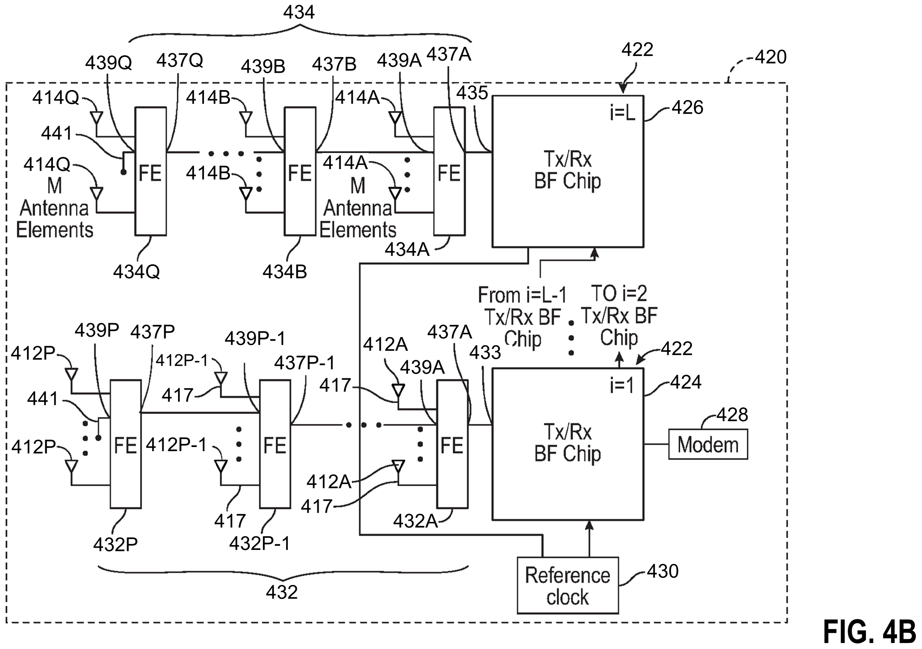

FIG. 4A is a diagram illustrating an example top view of an antenna lattice 406, in accordance with some examples of the present disclosure. The antenna lattice 406 can be part of a phased array antenna system, as further described below with respect to FIG. 4B. The antenna lattice 406 can include antenna elements 410A-410N (collectively "410"), 412A-412N (collectively "412"), 414A-414N (collectively "414") configured to transmit and/or send radio frequency signals. In some examples, the antenna elements 410, 412, 414 can be coupled to (directly or indirectly) corresponding amplifiers, as further described below with respect to FIG. 4B. The amplifiers can include, for example, low noise amplifiers (LNAs) in the receiving (Rx) direction or power amplifiers (PAs) in the transmitting (Tx) direction.

An antenna aperture 402 of the antenna lattice 406 can be an area through which power is radiated or received. A phased array antenna can synthesize a specified electric field (phase and amplitude) across the antenna aperture 402. The antenna lattice 406 can define the antenna aperture 402 and can include the antenna elements 410, 412, 414 arranged in a particular configuration that is supported physically and/or electronically by a PCB.

In some cases, the antenna aperture 402 can be grouped into subsets of antenna elements 404A and 404B. In some cases, each subset of antenna elements 404A, 404B of antenna elements can include an equal number N number of antenna elements 412, 414, which can be associated with specific beamformer (BF) chips as shown in FIG. 4B, where N is an integer. In some cases, the subsets of antenna elements 404A, 404B may include different numbers of antenna elements. The remaining antenna elements 410 in the antenna aperture 402 can be similarly associated with other BF chips (not shown).

FIG. 4B is a diagram illustrating an example phased array antenna system 420, in accordance with some examples. The phased array antenna system 420 can include an antenna lattice 406 including antenna elements 412, 414, and a BF lattice 422, which in this example includes BF chips 424, 426, for receiving signals from a modem 428 in the transmit (Tx) direction and sending signals to the modem 428 in the receive (Rx) direction. The antenna lattice 406 can be configured to transmit and/or receive a beam of radio frequency signals having a radiation pattern from or to the antenna aperture 402.

The BF chips 424, 426 in the BF lattice 422 can include an L number of BF chips. For example, BF chip 424 can include a first BF chip i (i=1, where i=1 to L), and so forth, and BF chip 426 can include the *L*ₜₕ BF chip *(i=L)* of the BF chips in the BF lattice 422. Each BF chip 424, 426 of the BF lattice 422 electrically couples with one or more serially fed signal distribution networks. For the purposes of illustration, the examples of FIG. 4B illustrate serially fed FE networks 432, 434. In some cases, the FEs of the serially fed FE networks serially fed FE network 432, 434 may perform amplification by PAs/LNAs and phase shifting by phase shifters included within individual FEs of a serially fed FE network. In other examples, serially fed signal distribution networks may exclude LNAs, PAs, and/or phase shifters without departing from the scope of the present disclosure.

In the example of FIG. 4B, a BF radio frequency input/output (RFIO) 433 of BF chip 424 is electrically coupled to serially fed FE network 432. Similarly, BF RFIO 435 of BF chip 426 is electrically coupled to serially fed FE network 434. Although one BF RFIO 433, 435 is shown for each BF chip 424, 426, each BF can include multiple BF RFIOs which can each couple to one or more serially fed FE networks. Although FIG. 4B illustrates a phased array antenna system including multiple BF chips 424, 426, in some cases, a phased array antenna system including a single BF chip 424 (e.g., L=1) can be used with serial fed FE networks (e.g., 432, 434) without departing from the scope of the present disclosure.

The phased array antenna system 420 can include serially fed FE networks 432, 434. Each serially fed FE network 432, 434 can include multiple individual FEs, with serial signal distribution between individual FEs of the serially fed FE networks 432, 434. For example, as illustrated in FIG. 4B, serially fed FE network 432 can include P individual FEs and serially fed FE network 434 can include *Q* individual FEs. In some embodiments, the number of individual FEs in each serially fed FE network 432, 434 of a phased array antenna system 420 can be equal (e.g., *P = Q).* However, there is no requirement for each of the serially fed FE networks 432, 434 in a phased array antenna system to include equal numbers of individual FEs.

In some cases, additional digital signals can be communicated between one or more BFs of the BF lattice and individual FEs of the serially fed FE networks. For example, digital signals (e.g., one or more clocks, control signals, or the like) can be provided to the serially fed FE networks 434 by the BF chips 424, 426 of the BF lattice 422. In some cases, the digital signals can be provided to each individual FE of the phased array antenna in parallel. In some cases, the digital signals can be provided to initial FEs (e.g., 432A, 434A) of the serially fed FE networks and serially distributed to the remaining individual FEs of the serially fed FE networks.

Referring to FIG. 4B, each of the individual FEs, 432A-432P of the serially fed FE network 432 can include an RF serial input 437A through 437P and RF serial output 439A through 439P. Similarly, each of the individual FEs 434A-434Q of the serially fed FE network 434 can include an RF serial input 437A through 437Q and an RF serial output 439A through 439Q. Each individual FE 432A-432P, 434A-434Q of the serially fed FE networks 432, 434 can interface with *M* antenna elements through coupling antenna traces 417. The value for *M* can be any positive integer. As used herein, the RF serial inputs 437A through 437P of serially fed FE network 432 and RF serial inputs 437A through 437Q of serially fed FE network 434 are collectively referred to as RF serial inputs 437. As used herein, the RF serial outputs 439A through 439P of serially fed FE network 432 and RF serial outputs 439A through 439Q of serially fed FE network 434 are collectively referred to as RF serial outputs 439. The terms "input" and "output" used to describe RF serial inputs 437 and RF serial outputs 439 are consistent with the phased array antenna system 420 operating in a transmit (Tx) configuration. However, for the purposes of consistently identifying the RF serial input 437 and RF serial output 439 of each individual FE, the descriptors "input" for RF serial input 437 and "output" RF serial output 439 are used whether the phased array antenna system 420 (or a subset of antenna elements of the phased array antenna system 420, such as antenna elements 404A, 404B of FIG. 4A) is operating in a transmit (Tx) configuration or a receive (Rx) configuration. In some cases, such as when the serially fed FE networks are used for both receiving and transmitting configurations, the RF serial inputs 437 and RF serial outputs 439 can also be referred to as RF serial input/outputs (IOs) herein.

As illustrated in FIG. 4B, M antenna elements 412A are coupled to individual FE 432A, M antenna elements 412P-1 are coupled to individual FE 432P-1, and so on with M antenna elements 412P coupled to individual FE 432P at the end of the serially fed FE network 432. Similarly, *M* antenna elements 414A are coupled to individual FE 434A, *M* antenna elements 414B are coupled to individual FE 434B, and so on with M antenna elements 412Q coupled to individual FE 432Q at the end of the serially fed FE network 434. In some implementations, the individual FEs of the serially fed FE networks 432, 434 can include circuitry for performing analog processing of RF signals received from and/or transmitted to the antenna elements 412, 414. In some implementations, the BF chips 424, 426 in combination with the serially fed FE networks 432, 434 can collectively form a hybrid beamforming network (e.g., including both analog and digital beamforming components). A hybrid beamforming network may also be referred to as a hybrid beamformer, HBF, or hybrid analog/digital beamformer herein. In some cases, the BFs and FEs can form an analog beamforming network without departing from the scope of the present disclosure. In some implementations, the BF chips illustrated in FIG. 4B can be replaced with any RF transceiver. For example, in the case of a phased array antenna system including a single serially fed FE network (e.g., one of serially fed FE networks 432, 434), a single transceiver can be used in place of a BF chip and beamforming functionality can be performed by the individual FEs of the serially fed FE network.

Each serially fed FE network 432, 434 can include an initial FE 432A, 434A, that interfaces with the BF chips 424, 426 and a first set of M antenna elements 412A, 414A. As used herein, references to an initial FE 432A, 434A means that the RF serial input 437A of the initial FE 432A, 434A is communicatively coupled to a BF IO and/or a distribution/combination network coupled to a corresponding BF IO. For example, an RF serial input 437A of initial FE 432A can communicatively couple with BF RFIO 433 of BF chip 424 and RF serial input 437A of the initial FE 434A can communicatively couple with BF RFIO 435 of BF chip 426. As illustrated, the RF serial output 439A of initial FE 432A of the serially fed FE network 432 can subsequently be coupled to the RF serial input 437B of FE 432B, and so on for each subsequent individual FE 432C through 432P to form serially fed FE network 432. Similarly, the RF serial output 439A of initial FE 434A of the serially fed FE network 434 can subsequently be coupled to the RF serial input 437B of FE 434B, and so on for each subsequent individual FE 434C through 434Q to form serially fed FE network 434.

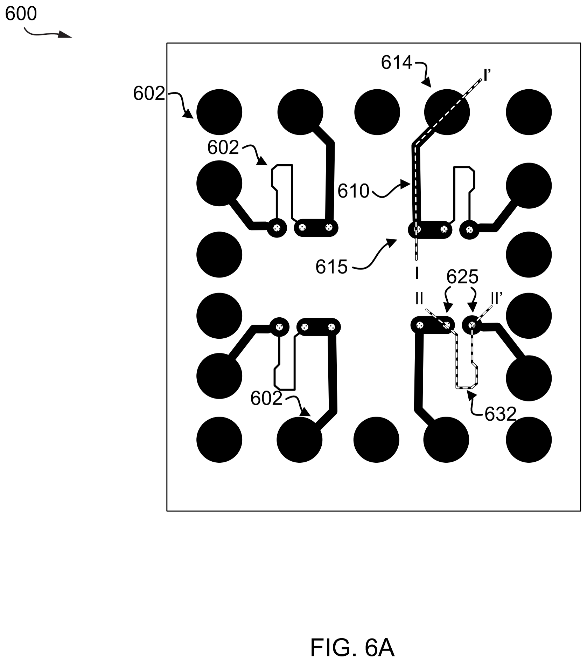

The serially fed FE networks (e.g., serially fed FE networks 432, 434) can be configured to provide the same gain between a BF RFIO (e.g., BF RFIO 433 of BF chip 424, BF RFIO 435 of BF chip 426) and each of the antenna elements (e.g., antenna elements 412, 414) coupled to the BF RFIO through the serially fed FE network. For example, a gain between the BF RFIO 433 and each antenna element 412A coupled to individual FE 432A and a gain between BF RFIO 433 and each antenna element 412P-1 coupled to individual FE 432P-1 can be equal to a common gain. In addition, a gain between the BF RFIO 433 and each antenna element 412P coupled to individual FE 432P can also be equal the common gain. In some cases, the gain between the BF RFIO 433 and different antenna elements of the antenna elements 412 coupled to the individual FEs of serially fed FE network 432 can be different. For example, gains between the BF RFIO 433 and antenna elements 412 can be configured to provide a desired excitation taper (e.g., an amplitude taper)
For the last individual FE 432P in the serially fed FE network 432 and last individual FE 434Q in serially fed FE network 434 there is no individual FE to couple to the RF serial output 439. As illustrated, the RF output of each last individual FE 432P, 434Q can be terminated with a matched termination 441. In some embodiments, the RF output of each last individual FE 432P, 434Q, and/or any associated signal conditioning components (see FIG. 6A) can be disabled. In some cases, disabling the RF output of a last individual FE 432P, 434Q can alleviate a requirement to terminate the RF output with an output termination.

In some implementations, each individual FE module 432A-432P, 434A-434Q of the serially fed FE networks 432, 434 can include RF or millimeter wave (mmWave) frontend integrated circuits, modules, devices, and/or any other type of frontend package and/or component(s). In some cases, the individual FEs 432A-432P, 434A-434Q of the serially fed FE networks 432, 434 can include multiple-input, multiple-output FEs interfacing with multiple antenna elements and one or more BF chips.

Each BF chip of the BF lattice 422 can include an integrated circuit (IC) chip or an IC chip package including a plurality of pins. In some cases, a first subset of the plurality of pins can be configured to communicate signals with a respective, electrically coupled BF chip(s) (e.g., if the BF chips are digital beamformers (DBFs)) in a daisy chain configuration), and/or modem 428 in the case of BF chip 424. A second subset of the plurality of pins can be configured to transmit/receive signals with M antenna elements, and a third subset of the plurality of pins can be configured to receive a signal from a reference clock 430. The BF chips in the BF lattice 422 may also be referred to as transmit/receive (Tx/Rx) BF chips, Tx/Rx chips, transceivers, BF transceivers, and/or the like. As described above, the BF chips may be configured for Rx communication, Tx communication, or both. Although the illustrated example of FIG. 4B shows components such as an ADC normally associated with DBFs, the BF chips 424 can be analog beamformers, DBFs, and in some cases simple transceivers without departing from the scope of the present disclosure.

In some cases, the BF chips 424, 426 in the BF lattice 422 can include amplifiers, phase shifters, mixers, filters, up samplers, down samplers, variable gain amplifiers (VGAs), and/or other electrical components. In the receiving direction (Rx), a beamformer function can include delaying signals arriving from each antenna element so the signals arrive to a combining network at the same time. In the transmitting direction (Tx), the beamformer function can include delaying the signal sent to each antenna element such that the signals arrive at the target location at the same time (or substantially the same time). This delay can be accomplished by using "true time delay" or a phase shift at a specific frequency. In some examples, each of the BF chips 424, 426 can be configured to operate in half duplex mode, where the BF chips 424, 426 switch between receive and transmit modes as opposed to full duplex mode where RF signals/waveforms can be received and transmitted simultaneously. In other examples, each of the BF chips 424, 426 can be configured to operate in full duplex mode, where RF signals/waveforms can be received and transmitted simultaneously.

Each individual FE within the serially fed FE networks 432, 434 electrically couples to a group of respective M number of antenna elements. In turn, the individual FEs 432A-432P, 434A-434Q of the serially fed FE networks 432, 434 collectively couple a BF RFIO 433, 435 from each BF chip to a respective M number of elements multiplied by the number of FEs in the corresponding serially fed FE network 432, 434. For example, BF RFIO 433 of BF chip 424 can electrically couple to *M*P* antenna elements 412 through serially fed FE network 432. Similarly, BF RFIO 435 of BF chip 426 can electrically couple to *M*Q* number of antenna elements 414 through serially fed FE network 434.

The serially fed FE networks 432, 434 can include various components, such as RF ports, phase shifters, amplifiers (e.g., PAs, LNAs, VGAs, etc.), signal conditioning components, and the like. In some examples, in Rx mode, the serially fed FE networks 432, 434 can provide a gain to RF contents of each Rx input (e.g., input from antenna traces 417 and/or Rx inputs received at RF serial outputs 439 in Rx mode), and low noise power to suppress the signal-to-noise ratio impacts of noise contributors downstream in the Rx chain/path. In some cases, the serially fed FE networks 432, 434 can be configured to provide an equal gain between each individual antenna element of the antenna elements 412, 414 and a corresponding BF RFIO 433, 435. For example, a signal received at antenna element 414Q and a signal received at antenna element 414A can have equal gain along the path to BF RFIO 435.

Moreover, in Tx mode, the serially fed FE networks 432, 434 can provide gain to each Tx path (e.g., output to traces 417 and/or Tx outputs transmitted from RF serial outputs 439 in Tx mode) and drive RF power into a corresponding antenna element 412, 414. In some cases, the serially fed FE networks 432, 434 can be configured to provide an equal gain between each BF RFIO and each corresponding individual antenna element of the antenna elements 412, 414. For example, a signal transmitted from BF RFIO 433 can have an equal gain at antenna element 412A and antenna element 412P-1. In some cases, the serially fed FE networks 432, 434 can be configured to provide gains between the BF RFIOs 433, 435 and different individual antenna elements of the antenna elements 412, 414. For example, the gain to different individual antenna elements can be set to provide an excitation taper (e.g., an amplitude taper) to the antenna elements 412, 414.

In the illustrated example of FIG. 4B, the BF chips in the BF lattice 422 are electrically coupled to each other in a daisy chain arrangement. In some cases, such as where the BF chips are analog BF chips, digital communication between BFs by a daisy chain arrangement can be excluded. The BF chips are also coupled to serially fed FE networks 432, 434 that include analog beamforming functionality in a hybrid beamforming network. The serially fed FE networks 432, 434 can be used in many different configurations without departing from the scope of the present disclosure. For example, the serially fed FE networks 432 can be used with analog BFs, digital BFs, transceivers, receivers, and/or transmitters. As another example, in some cases, aspects of the disclosure can be implemented using BFs and/or FEs having different arrangement(s) and/or electrical coupling structure(s).

In some cases, serially fed FE networks 432, 434 can be used to increase the ratio of antenna elements to BF RFIOs (e.g., BF RFIOs 433, 435). However, in some cases, single stage FEs may be used without departing from the present disclosure. As used herein, single stage FEs refer to FEs with an RFIO connected to a BF RFIO (e.g., BF RFIOs 433, 435) but without RF serial connections to other FEs. In some cases, the number of antenna elements coupled to each single stage FE and/or the number of BF RFIOs of the BF chips in the BF lattice 422 can be provided as an alternative ways of coupling BF chips in the BF lattice 422 to additional antenna elements.

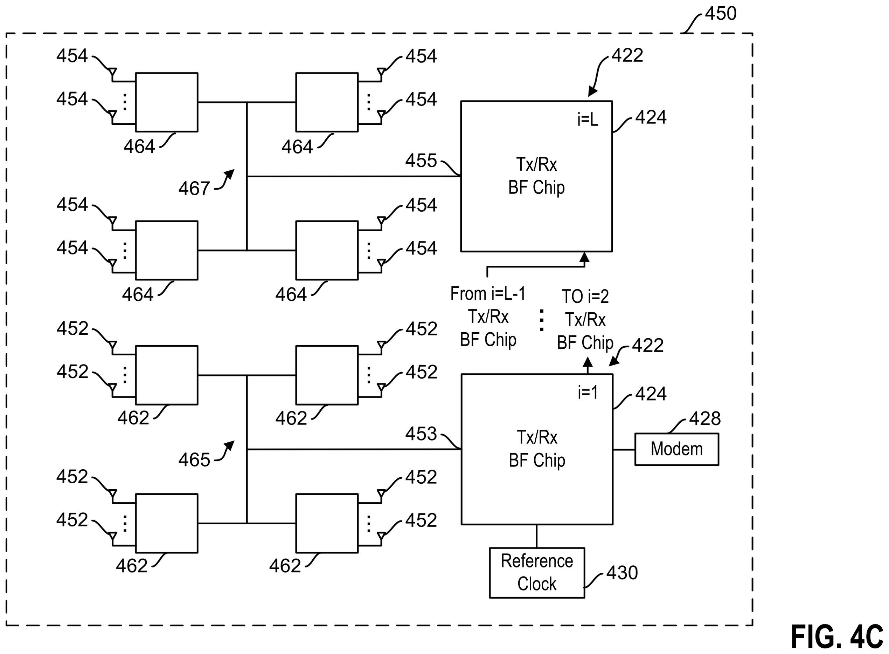

FIG. 4C is a diagram illustrating an additional example phased array antenna system 450. The phased array antenna system 450 can include an antenna lattice 406 including antenna elements 452, 454. The BF lattice 422, BF chips 424, 426, modem 428, and reference clock 430 can be similar to and perform similar functions to like numbered elements of FIG. 4B.

In the example of FIG. 4C, a BF radio frequency input/output (RFIO) 453 of BF chip 424 is electrically coupled to a distribution/combination network 465 (e.g., an H-network). Similarly, BF RFIO 455 of BF chip 426 is electrically coupled to a distribution/combination network 467 (e.g., an H-network). Although one BF RFIO 453, 455 is shown for each BF chip 424, 426, each BF can include multiple BF RFIOs which can each couple to one or more serially fed FE networks. Although FIG. 4C illustrates a phased array antenna system including multiple BF chips 424, 426, in some cases, a phased array antenna system including a single BF chip 424 (e.g., L=1) can be used with serial fed FE networks (e.g., 432, 434) without departing from the scope of the present disclosure.

The phased array antenna system 450 can include front end modules (FEMs) 462 coupled by the distribution/combination network 465 to BF RFIO 453 of BF chip 424. Similarly, FEMs 464 can be coupled by the distribution/combination network 467 to BF RFIO 455.

In some cases, additional digital signals can be communicated between one or more BFs of the BF lattice and individual FEs of the serially fed FE networks. For example, digital signals (e.g., one or more clocks, control signals, or the like) can be provided to the serially fed FE networks 434 by the BF chips 424, 426 of the BF lattice 422. In some cases, the digital signals can be provided to each FEM 462, 464 of the phased array antenna in parallel.

As illustrated in FIG. 4C, M antenna elements 452 are coupled each respective FEM 462. Similarly, M antenna elements 454 are coupled to each respective FEM 464. In some implementations, the FEMs 462, 464 can include circuitry for performing analog processing of RF signals received from and/or transmitted to the antenna elements 452, 454. In some implementations, the BF chips 424, 426 in combination with the FEMs 462, 464 can collectively form a hybrid beamforming network (e.g., including both analog and digital beamforming components). A hybrid beamforming network may also be referred to as a hybrid beamformer, HBF, or hybrid analog/digital beamformer herein. In some cases, the BFs and FEMs can form an analog beamforming network without departing from the scope of the present disclosure.

In some implementations, each individual FEM of the FEMs 462, 464 can include RF or mmWave frontend integrated circuits, modules, devices, and/or any other type of frontend package and/or component(s). In some cases, the individual FEMs of the FEMs 462, 464 can include multiple-input, multiple-output FEMs interfacing with multiple antenna elements and one or more BF chips.

The FEMs 462, 464 can include various components, such as RF ports, phase shifters, amplifiers (e.g., PAs, LNAs, VGAs, etc.), signal conditioning components, and the like. In some examples, in Rx mode, the FEMs 462, 464 can provide a gain to RF contents of each Rx input (e.g., input from antenna elements 452, 454), and low noise power to suppress the signal-to-noise ratio impacts of noise contributors downstream in the Rx chain/path.

Moreover, in Tx mode, the FEMs 462, 464 can provide gain to each Tx path (e.g., output to antenna elements 452, 454) and drive RF power into a corresponding antenna element. In some cases, the FEMs 462, 464 can be configured to provide gains between the BF RFIOs 453, 455 and different individual antenna elements of the antenna elements 452, 454. For example, the gain to different individual antenna elements can be set to provide an excitation taper (e.g., an amplitude taper) to the antenna elements 452, 454.

In the illustrated example of FIG. 4C, the BF chips in the BF lattice 422 are electrically coupled to each other in a daisy chain arrangement. In some cases, such as where the BF chips are analog BF chips, digital communication between BFs by a daisy chain arrangement can be excluded. The BF chips are also coupled to FEMs 462, 464 that include analog beamforming functionality in a hybrid beamforming network. The FEMs 462, 464 can be used in many different configurations without departing from the scope of the present disclosure. For example, the FEMs 462, 464 can be used with analog BFs, digital BFs, transceivers, receivers, and/or transmitters. As another example, in some cases, aspects of the disclosure can be implemented using BFs and/or FENs having different arrangement(s) and/or electrical coupling structure(s).

In some cases, distribution/combination networks 465, 467 can be used to increase the ratio of antenna elements to BF RFIOs (e.g., BF RFIOs 453, 455). For example, FIG. 4C illustrates each BF RFIO 453, 455 being coupled to four FEMs 462, 464. However, in some cases, each BF RFIO 453, 455 may be coupled to more (e.g., greater than four) or fewer (e.g, one or two) FEMs 462, 464 without departing from the present disclosure. In some cases, the number of antenna elements coupled to each FEM 462, FEM 464 and/or the number of BF RFIOs of the BF chips in the BF lattice 422 can be provided as an alternative ways of coupling BF chips in the BF lattice 422 to additional antenna elements.

### MAIN LOBE AND SIDE LOBES EMANATING FROM A PHASED ARRAY ANTENNA

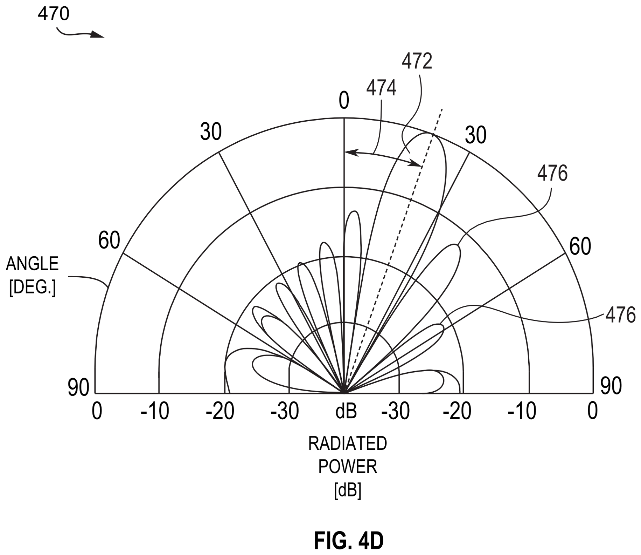

FIG. 4D shows a schematic 470 illustrating an example main lobe 472 and side lobes 476 emanating from an antenna array of an example phased array antenna system (e.g., antenna apparatus 200 of FIG. 2A). The schematic 470 may represent a polar plot, whereby the main lobe 472 and the various side lobes 476 represent a radiation pattern, or effective isotropic radiation pattern (EIRP), of the phased array antenna system. As illustrated in FIG. 4D, the main lobe 472 may have a larger field strength compared to other lobes (e.g., side lobes 476) resulting from the transmission of the signal. The main lobe 472 may correspond to the beam steering direction 474 of the signal from a transmitting phased array antenna system to a receiving system (e.g., a receiving phased array antenna system, a SAT 102 of FIG. 1A, a SAG 104 of FIG. 1A, a UT 112 of FIG. 1A). The other lobes, or side lobes 476, may be the result of the size/shape of the array aperture (e.g., antenna aperture 402 of FIG. 4A and any kind of excitation taper (e.g., amplitude taper) applied to the antenna array. In some cases, the example main lobe 472 and side lobes 476 may be associated with a single data beam. In some cases, a data beam may also be referred to as data signals, data streams, or the like.

In some cases, a phased array antenna system may be capable of transmitting and/or receiving multiple data beams. In some examples, each data beam may be associated with a corresponding beam steering direction (e.g., beam steering direction 474). In some cases, two or more data beams may be associated with a particular frequency band. In some examples, a phased array antenna system may be configured to transmit and/or receive data beams associated with two or more different frequency bands (e.g., Ka band, K band, Ku band, V band, W band, G band, mm wave, or the like). In some cases, each data beam may be associated with a corresponding EIRP, which may include a main lobe (e.g., main lobe 472) and various side lobes (e.g., side lobes 476).

### EXAMPLES

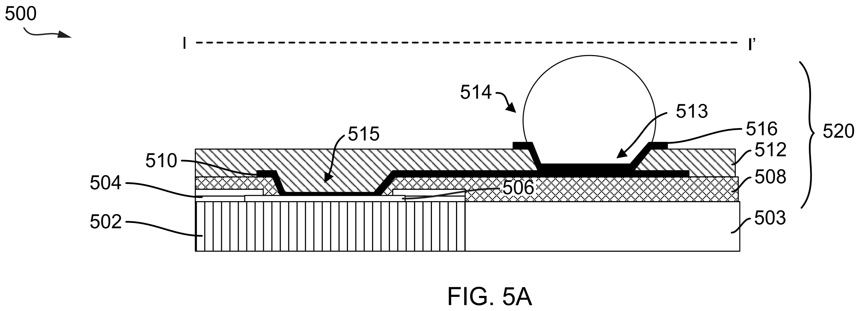

Various examples of providing electrical connections and/or passive components utilizing a redistribution layer are provided with respect to FIG. 5A through FIG. 7C below.

FIG. 5A through FIG. 5C are diagrams illustrating cross-sections of material stackups for providing electrical connections and/or passive components utilizing a redistribution layer.

FIG. 5A is a diagram illustrating a cross-section of a material stackup 500 for providing electrical connections utilizing a redistribution layer. In the example of FIG. 5A, the cross-section can correspond to the cut line I-I'shown in FIG. 6A.

In the example of FIG. 5A, the material stackup includes a semiconductor layer 502 (e.g., Silicon, Silicon-Germanium, Gallium-Arsenide, or the like). In some cases, an optional additional substrate 503 may be disposed around a perimeter of the semiconductor layer (e.g., around a perimeter of a diced IC chip). In some cases, a passivation layer 504 can be disposed on a surface of the semiconductor layer 502 to form a physical barrier to prevent unwanted contact with the metal layers and/or other surface features created on the semiconductor layer during a semiconductor fabrication process. For example, the metal layers formed during the semiconductor fabrication process may include a metal layer 506. In one illustrative example, the metal layer 506 may be an uppermost metal layer in a semiconductor fabrication process.

As shown in FIG. 5A, a redistribution layer 510 (e.g, an additional metal layer added after the semiconductor fabrication process can be utilized to physical and electrically couple the metal layer 506 to a conductive structure 514 (e.g., a solder ball). In some cases, a first dielectric layer 508 can be disposed on a surface of the semiconductor layer 502, passivation layer 504, exposed portions of the metal layer 506 and/or the additional substrate 503. In some cases, an opening 515 can be created within the first dielectric layer 508 that allows access to the metal layer 506 for forming a metal connection with the redistribution layer 510. In some implementations, a second dielectric layer 512 can be disposed on the first dielectric layer 508 and the redistribution layer 510 to form a physical barrier to prevent unwanted contact with the redistribution layer 510. As illustrated in FIG. 5A, metal can be deposited in an opening 513 in the second dielectric layer 512 to allow access to the redistribution layer at the location of a conductive structure 514. In one illustrative example, the conductive structure 514 can be a solder ball. In some cases, additional metal 516 may be deposited at the opening 513 in the second dielectric layer 512 to form a connection point for the conductive structure 514. In some cases, the first dielectric layer 508, redistribution layer 510, and second dielectric layer 512, and/or conductive structure 514 can be components of an interposer 520.

Referring to FIG. 6A, an example IC chip package 600 illustrates the use of a redistribution layer 602 (as indicated by a black color) for providing electrical connections. In the example of FIG. 6A, the cut line I-I' includes a via 615, a routing trace 610, and a conductive structure 614 (e.g., a solder ball). The via 615 includes a metal layer of an RFIC chip as indicated by a dotted pattern coupled to the redistribution layer 602. The metal layer of the RFIC chip can correspond to the metal layer 506 of FIG. 5A. As illustrated in FIG. 6A, the redistribution layer 602 includes a routing trace 610 coupled to a conductive structure 614. The portions of the redistribution layer 602 along the cut-line I-I' can correspond to the redistribution layer 510 of FIG. 5A.

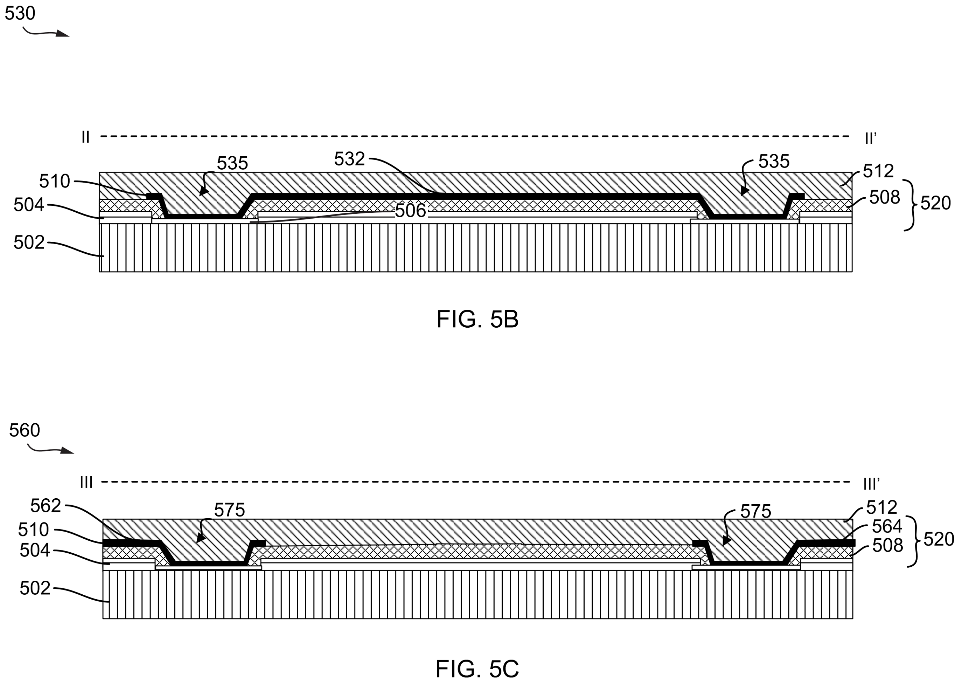

FIG. 5B is a diagram illustrating a cross-section of a material stackup 530 for providing a passive component 532 on a redistribution layer 510. In the example of FIG. 5B, the cross-section can correspond to the cut line II-II'shown in FIG. 6A. In the example of FIG. 5B, the semiconductor layer 502, passivation layer 504, metal layer 506, first dielectric layer 508, redistribution layer 510, and second dielectric layer 512 can correspond to like numbered components of FIG. 5A. As illustrated in FIG. 5B, in some cases, the redistribution layer 510 can be utilized to create a passive component 532 outside of the metal layers (e.g., metal layer 506) formed on the semiconductor layer 502 during the semiconductor fabrication process. As shown in FIG. 5B, terminal ends 535 of the redistribution layer 510 can be coupled to the metal layer 506 at different opening in the passivation layer 504. In such an example, the passive component 532 may utilize free area on the interposer 520 for passive electrical components that may otherwise occupy area on the semiconductor layer 502. As shown in FIG. 5B, the portion of the redistribution layer 510 that includes the passive component 532 may not include any openings for a connection to a conductive structure (e.g., conductive structure 514 of FIG. 5A).

Returning to FIG. 6A, the example IC chip package 600 further illustrates the use of the redistribution layer 602 (as indicated by a black color) for providing passive electrical components. In the example of FIG. 6A, the cut line II-II' includes vias 625 at opposing ends of the passive component 632. In the example of FIG. 6A, the passive component 632 can represent an impedance matching component (e.g., an inductor, a choke, or the like) for matching an output impedance of a power amplifier to a load (e.g., an antenna element). In the example of FIG. 6A, the vias 625 can correspond to coupling of the terminal ends 535 of the passive component 532 of FIG. 5A to the metal layer 506 of FIG. 5A.

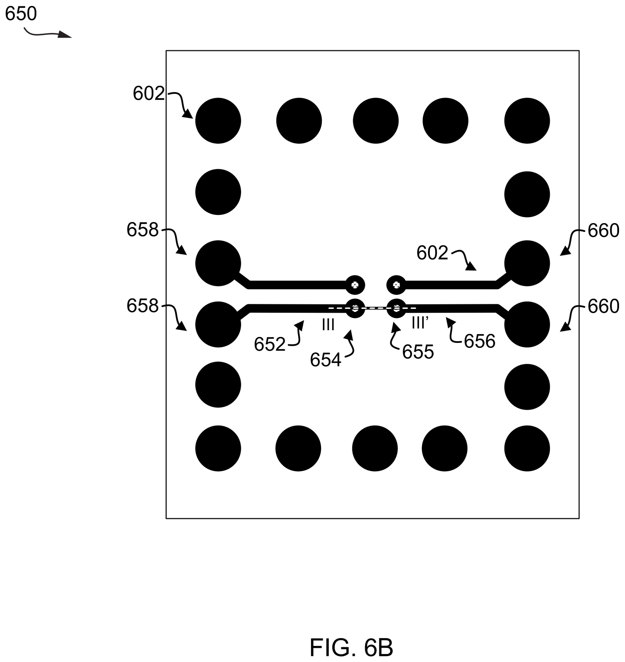

FIG. 5C is a diagram illustrating a cross-section of an additional material stackup 560 for providing passive components on a redistribution layer 510. In the example of FIG. 5C, the cross-section can correspond to the cut line III-III'shown in FIG. 6B. In the example of FIG. 5C, the semiconductor layer 502, passivation layer 504, metal layer 506, first dielectric layer 508, redistribution layer 510, and second dielectric layer 512 can correspond to like numbered components of FIG. 5A. As illustrated in FIG. 5C, in some cases, the redistribution layer 510 can be utilized to create passive components 562, 564 outside of the metal layers (e.g., metal layer 506) formed on the semiconductor layer 502 during the semiconductor fabrication process. As shown in FIG. 5C, terminal ends 575 of the passive components 562, 564 can be coupled to the metal layer 506 at different opening in the passivation layer 504. In such an example, the passive components 562, 564 may utilize free area on the interposer 520 for passive electrical components that may otherwise occupy area on the semiconductor layer 502.

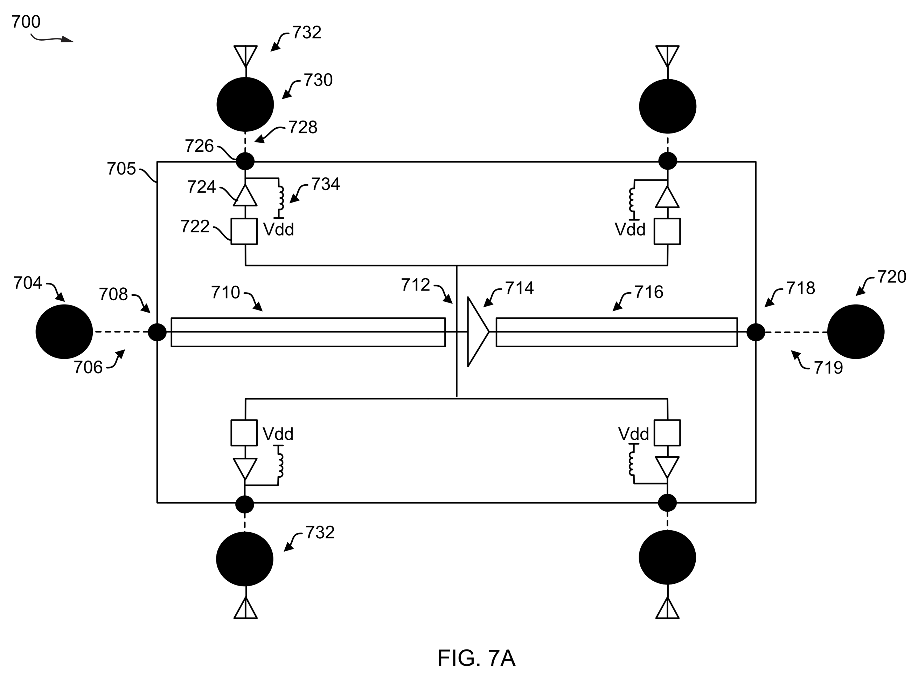

Referring to FIG. 6B, an example IC chip package 650 illustrates the use of a redistribution layer 602 (as indicated by a black color) to provide passive components 652, 656 (e.g., coplanar striplines). In the example of FIG. 6A, the cut line III-III' includes a first passive component, vias 654, 655 and a second passive component 656. The vias 654, 655 include a metal layer of an RFIC chip as indicated by a dotted pattern. The vias couple the metal layer of the RFIC chip to the redistribution layer 602. The metal layer of the RFIC chip can correspond to the metal layer 506 of FIG. 5C. The portions of the redistribution layer 602 along the cut-line III-III' can correspond to the redistribution layer 510 of FIG. 5A. In the example of FIG. 6B, the passive component 652 may be a coplanar stripline. For example, an RF signal may be coupled to the passive component 652 from a printed circuit board (PCB) through solder balls 658 coupled to the redistribution layer 602. In some cases, the RF signal may couple to active and/or passive components within the RFIC through the vias 654, 655. For example, the RFIC may include an amplifier or buffer (e.g., amplifier 714 of FIG. 7A through FIG. 7C). The RF signal may enter the RFIC through the vias 654 and provided to the various active and/or passive components within the RFIC. In some cases, after being acted upon by the components of the RFIC, a serial RF signal for distribution to one or more serially connected RFICs (e.g., individual FEs of serially fed FE networks 432, 434 of FIG. 4B) may be output from the RFIC by vias 654. As illustrated in FIG. 6B, a passive component 656 (e.g., a coplanar stripline) may be coupled to the vias. In some cases, the passive component 656 may be output through solder balls 660 coupled to a PCB for distribution to the one or more serially connected RFICs.

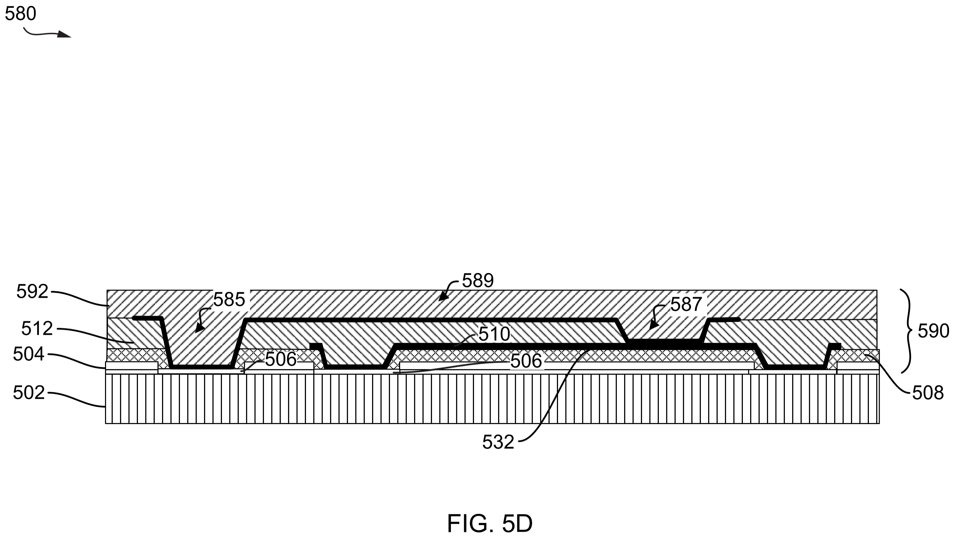

FIG. 5D is a diagram illustrating a cross-section of a material stackup 580 for providing an interposer with multiple metal layers. In the example of FIG. 5D, the semiconductor layer 502, passivation layer 504, metal layer 506, first dielectric layer 508, redistribution layer 510, and second dielectric layer 512 can correspond to like numbered components of FIG. 5A. However, in FIG. 5D, the interposer 590 may include a third dielectric layer 592 in addition to the first dielectric layer 508 and the second dielectric layer 512. As shown in FIG. 5D, the third dielectric layer 592 can be disposed on top of the second dielectric layer 512.

In some cases, prior to applying the third dielectric layer 592, an opening 585 can be formed in the first dielectric layer 508 and the second dielectric layer 512 to allow for access to the metal layer 506 on the semiconductor layer 502. In some cases, an additional redistribution layer 589 may be deposited on a surface of the second dielectric layer. In some examples, an opening 587 can be formed in the second dielectric layer 512 to expose the redistribution layer 510. As illustrated, the additional redistribution layer 589 may be deposited in the opening 587 such that the additional redistribution layer 589 electrically couples to the redistribution layer 510. In some cases, after the additional redistribution layer 589 is deposited, the third dielectric layer 592 may be provided to prevent physical contact with the additional redistribution layer 589 and/or other features of the interposer 590 and/or the semiconductor layer 502. It should be understood that multiple redistribution layers 510, 589 may also be utilized to form passive components and/or routing as shown with respect to FIG. 5A through FIG. 5C. In one illustrative example, the redistribution layers 510, 589 may be utilized to form a transformer passive component.

FIG. 7A through FIG. 7C are simplified schematic diagrams illustrating removal of RF passive components from an RFIC using a redistribution layer. Referring to FIG. 7A, the schematic diagram 700 illustrates an example of an RFIC 705. In one illustrative example, the RFIC 705 can correspond to an individual FEM of serially fed FE networks 432, 434 of FIG. 4B. In the example of FIG. 7A, solder balls 704, 720, 730, routing traces 706, 719, 728 (shown as dashed lines), and antenna elements 732 can be external to the RFIC 705. For example, the solder balls 704, 720, 730 may be utilized to couple the RFIC 705 to a PCB. In some cases, a redistribution layer (e.g., redistribution layer 510 of FIG. 5A through FIG. 5C) may be utilized to form the solder balls 704, 720, 730 and the routing traces 706, 719, 728. In some examples, vias 708, 726 may correspond to a connection between a metal layer of the RFIC 705 (e.g., metal layer 506 of FIG. 5A) and the redistribution layer (e.g., redistribution layer 510 of FIG. 5A).

In the example of FIG. 7A, an RF signal may flow through a through-path of the RFIC 705 as an RF input from a PCB through the solder ball 704. The solder ball can be connected to the via 708 by through routing trace 706 using the redistribution layer on an interposer (e.g., interposer 520 of FIG. 5A). As shown in FIG. 7A, a transmission line 710 (e.g., a microstrip line, or the like) can be used to couple the via 708 to an amplifier 714. The amplifier 714 may perform signal condition on the RF input signal (e.g., by adjusting gain and/or phase) and output an RF serial signal to be distributed to a subsequent RFIC serially coupled to the RFIC 705. As illustrated, a transmission line 716 included within the RFIC 705 can be utilized to connect the output of the amplifier 714 to a via 718. In some examples, the transmission lines 710, 716 can be implemented as coplanar striplines (e.g., for a differential signal), microstrip line(s), or the like. The via 718 can be coupled by routing trace 719 to a solder ball 720.

In addition to the through-path, the RFIC 705 includes a distribution network 712 for distributing the RF input to signal chains for antenna elements 732. As illustrated in FIG. 7A, each signal chain can include a phase shifter 722, a power amplifier 724, a via 726, a routing trace 728, a solder ball 730, and an antenna element 732. As shown in FIG. 7A, a matching circuit 734, (e.g., an inductor or choke) coupled to a supply voltage Vdd can formed internally to the RFIC 705 using one or more metal layers of a semiconductor fabrication process.

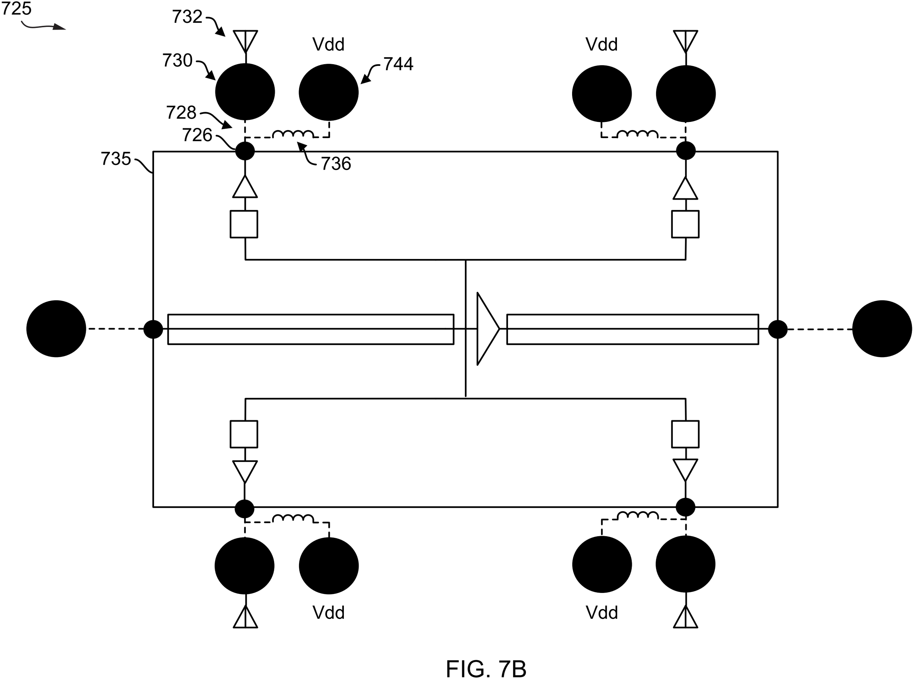

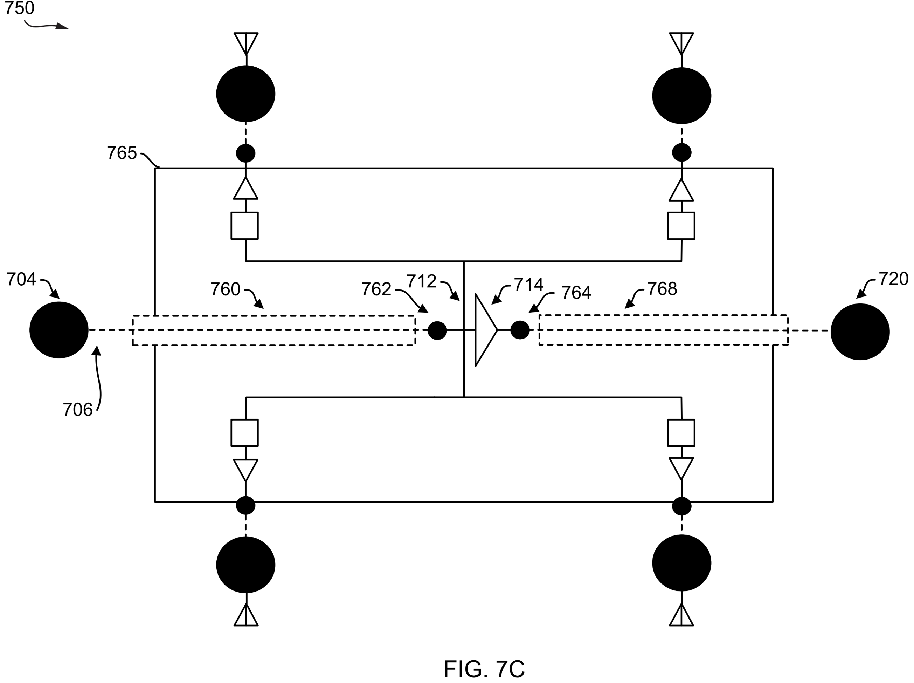

Referring to FIG. 7B, the schematic diagram 725 illustrates an example of an RFIC 735 in which a passive component (e.g., matching circuit 734) is moved outside of the RFIC and formed on a redistribution layer (e.g., redistribution layer 510 of FIG. 5A). As illustrated in FIG. 7B, a matching circuit 736 (e.g., an inductor or choke) can be formed on a redistribution layer. Furthermore, as shown in FIG. 7C, a connection between the matching circuit 736 and the supply voltage Vdd can be provided by a solder ball 744 (e.g, conductive structure 514 of FIG. 5A) coupled to the redistribution layer. In some cases, by removing relatively large passive components such as a matching network from an RFIC, the total area of the RFIC can be reduced and/or additional space can be allocated for other components within the RFIC.

Referring to FIG. 7C, the schematic diagram 750 illustrates an example of an RFIC 765 in which passive components (e.g., transmission line 710, transmission line 716 of FIG. 7A) are moved outside of the RFIC and formed on a redistribution layer (e.g., redistribution layer 510 of FIG. 5A). As illustrated in FIG. 7C, transmission lines 760, 768 can be formed on the redistribution layer (e.g., redistribution layer 510 of FIG. 5A). As shown in FIG. 7C, vias 762, 764 can be positioned centrally near the distribution network 712 and amplifier 714 to allow for distribution of the RF input signal and signal conditioning of the RF input signal by the amplifier 714 (e.g., by adjusting gain and/or phase). In some cases, by removing relatively large passive components such as transmissions lines from an RFIC, the total area of the RFIC can be reduced and/or additional space can be allocated for other components within the RFIC.

While the examples of FIG. 5A through FIG. 7C illustrate various passive components provided on a redistribution layer (e.g., redistribution layer 510 of FIG. 5A, redistribution layer 602 of FIG. 6A), it should be understood that the provided examples (e.g., passive component 632 of FIG. 6A, passive component 652, passive component 656 of FIG. 6B, matching circuit 736 of FIG. 7B, transmission lines 760, 768 of FIG. 7C) are for the purposes of illustration only. Example passive components that can be formed on one or more redistribution layers can include, without limitation, resistors, capacitors, inductors, microstrip lines, coplanar strip lines, or the like.

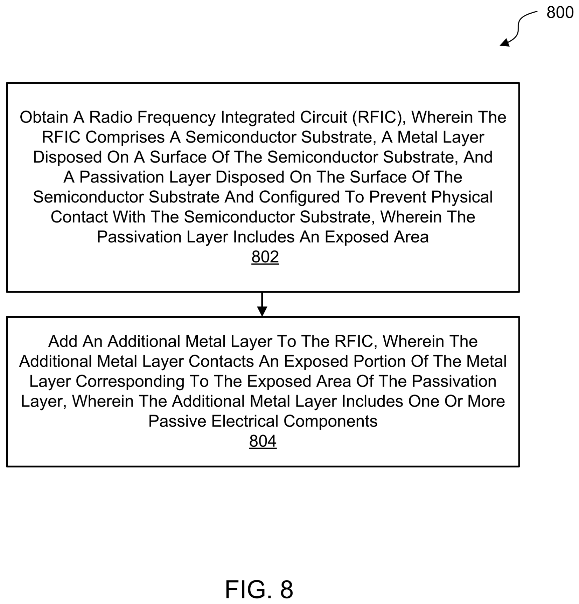

Having disclosed example systems, components and concepts, the disclosure now turns to the example process 800 for providing off-chip passive components for RFICs, as shown in FIG. 8. The steps outlined herein are non-limiting examples provided for illustration purposes, and can be implemented in any combination thereof, including combinations that exclude, add, or modify certain steps.

At block 802, the process 800 includes obtaining an RFIC, wherein the RFIC comprises a semiconductor substrate, a plurality of metal layers disposed on a surface of the semiconductor substrate, and a passivation layer disposed on the surface of the semiconductor substrate and configured to prevent physical contact with the semiconductor substrate. In some implementations, the passivation layer includes an exposed area.

At block 804, the process 800 includes an additional metal layer to the RFIC. In some cases, the additional metal layer contacts an exposed portion of the metal layer corresponding to the exposed area of the passivation layer. In some implementations, the additional metal layer includes one or more passive electrical components.

Specific details are provided in the description above to provide a thorough understanding of the embodiments and examples provided herein. However, it will be understood by one of ordinary skill in the art that the embodiments may be practiced without these specific details. For clarity of explanation, in some instances the present technology may be presented as including individual functional blocks comprising devices, device components, steps or routines in a method embodied in software, or combinations of hardware and software. Additional components may be used other than those shown in the figures and/or described herein. For example, circuits, systems, networks, processes, and other components may be shown as components in block diagram form in order not to obscure the embodiments in unnecessary detail. In other instances, well-known circuits, processes, algorithms, structures, and techniques may be shown without unnecessary detail in order to avoid obscuring the embodiments.

Individual embodiments may be described above as a process or method which is depicted as a flowchart, a flow diagram, a data flow diagram, a structure diagram, or a block diagram. Although a flowchart may describe the operations as a sequential process, many of the operations can be performed in parallel or concurrently. In addition, the order of the operations may be re-arranged. A process is terminated when its operations are completed, but could have additional steps not included in a figure. A process may correspond to a method, a function, a procedure, a subroutine, a subprogram, etc. When a process corresponds to a function, its termination can correspond to a return of the function to the calling function or the main function.

Processes and methods according to the above-described examples can be implemented using signals and/or computer-executable instructions that are stored or otherwise available from computer-readable media. Such instructions can include, for example, instructions and data which cause or otherwise configure a general purpose computer, special purpose computer, or a processing device to perform a certain function or group of functions. Portions of computer resources used can be accessible over a network. The computer executable instructions may be, for example, binaries, intermediate format instructions such as assembly language, firmware, source code. Examples of computer-readable media that may be used to store instructions, information used, and/or information created during methods according to described examples include magnetic or optical disks, flash memory, USB devices provided with non-volatile memory, networked storage devices, and so on.

Devices implementing processes and methods according to these disclosures can include hardware, software, firmware, middleware, microcode, hardware description languages, or any combination thereof, and can take any of a variety of form factors. When implemented in software, firmware, middleware, or microcode, the program code or code segments to perform the necessary tasks (e.g., a computer-program product) may be stored in a computer-readable or machine-readable medium. A processor(s) may perform the necessary tasks. Typical examples of form factors include laptops, smart phones, mobile phones, tablet devices or other small form factor personal computers, personal digital assistants, rackmount devices, standalone devices, and so on. Functionality described herein also can be embodied in peripherals or add-in cards. Such functionality can also be implemented on a circuit board among different chips or different processes executing in a single device, by way of further example.

The instructions, media for conveying such instructions, computing resources for executing them, and other structures for supporting such computing resources are example means for providing the functions described in the disclosure.

In the foregoing description, aspects of the application are described with reference to specific embodiments thereof, but those skilled in the art will recognize that the application is not limited thereto. Thus, while illustrative embodiments of the application have been described in detail herein, it is to be understood that the inventive concepts may be otherwise variously embodied and employed, and that the appended claims are intended to be construed to include such variations, except as limited by the prior art. Various features and aspects of the above-described application may be used individually or jointly. Further, embodiments can be utilized in any number of environments and applications beyond those described herein without departing from the broader spirit and scope of the specification. The specification and drawings are, accordingly, to be regarded as illustrative rather than restrictive. For the purposes of illustration, methods were described in a particular order. It should be appreciated that in alternate embodiments, the methods may be performed in a different order than that described.

One of ordinary skill will appreciate that the less than ("<") and greater than (">") symbols or terminology used herein can be replaced with less than or equal to (" ≤ ") and greater than or equal to (" ≥ ") symbols, respectively, without departing from the scope of this description.

Where components are described as being "configured to" perform certain operations, such configuration can be accomplished, for example, by designing electronic circuits or other hardware to perform the operation, by programming programmable electronic circuits (e.g., microprocessors, or other suitable electronic circuits) to perform the operation, or any combination thereof.

Claim language or other language in the disclosure reciting "at least one of" a set and/or "one or more" of a set indicates that one member of the set or multiple members of the set (in any combination) satisfy the claim. For example, claim language reciting "at least one of A and B" or "at least one of A or B" means A, B, or A and B. In another example, claim language reciting "at least one of A, B, and C" or "at least one of A, B, or C" means A, B, C, or A and B, or A and C, or B and C, or A and B and C. The language "at least one of" a set and/or "one or more" of a set does not limit the set to the items listed in the set. For example, claim language reciting "at least one of A and B" or "at least one of A or B" can mean A, B, or A and B, and can additionally include items not listed in the set of A and B.

The various illustrative logical blocks, modules, circuits, and algorithm steps described in connection with the examples disclosed herein may be implemented as electronic hardware, computer software, firmware, or combinations thereof. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present application.

The techniques described herein may also be implemented in electronic hardware, computer software, firmware, or any combination thereof. Such techniques may be implemented in any of a variety of devices such as general purposes computers, wireless communication devices, or integrated circuit devices having multiple uses including application in wireless communications and other devices. Any features described as modules or components may be implemented together in an integrated logic device or separately as discrete but interoperable logic devices. If implemented in software, the techniques may be realized at least in part by a computer-readable data storage medium comprising program code including instructions that, when executed, performs one or more of the methods, algorithms, and/or operations described above. The computer-readable data storage medium may form part of a computer program product, which may include packaging materials. The computer-readable medium may comprise memory or data storage media, such as random access memory (RAM) such as synchronous dynamic random access memory (SDRAM), read-only memory (ROM), non-volatile random access memory (NVRAM), electrically erasable programmable read-only memory (EEPROM), FLASH memory, magnetic or optical data storage media, and the like. The techniques additionally, or alternatively, may be realized at least in part by a computer-readable communication medium that carries or communicates program code in the form of instructions or data structures and that can be accessed, read, and/or executed by a computer, such as propagated signals or waves.

The program code may be executed by a processor, which may include one or more processors, such as one or more digital signal processors (DSPs), general purpose microprocessors, an application specific integrated circuits (ASICs), field programmable logic arrays (FPGAs), or other equivalent integrated or discrete logic circuitry. Such a processor may be configured to perform any of the techniques described in this disclosure. A general purpose processor may be a microprocessor; but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration. Accordingly, the term "processor," as used herein may refer to any of the foregoing structure, any combination of the foregoing structure, or any other structure or apparatus suitable for implementation of the techniques described herein.

While illustrative embodiments have been illustrated and described, it will be appreciated that various changes can be made therein without departing from the spirit and scope of the disclosure.

## Claims

1. A method of for providing off-chip passive components for radio frequency integrated circuits (RFICs), the method comprising:
obtaining an RFIC, wherein the RFIC comprises:
a semiconductor substrate;
a metal layer disposed on a surface of the semiconductor substrate; and
a passivation layer disposed on the surface of the semiconductor substrate and configured to prevent physical contact with the semiconductor substrate, wherein the passivation layer includes an exposed area; and
adding an additional metal layer to the RFIC, wherein the additional metal layer contacts an exposed portion of the metal layer corresponding to the exposed area of the passivation layer, wherein the additional metal layer includes one or more passive electrical components.

2. The method of claim 1, further comprising depositing a dielectric layer on the surface of the semiconductor substrate, wherein the dielectric layer covers the exposed area of the passivation layer.

3. The method of claim 2, further comprising removing a portion of the dielectric layer, the portion of the dielectric layer corresponding to the exposed area of the passivation layer.

4. The method of claim 3, wherein removing at least the portion of the dielectric layer comprises laser etching or focused ion beam etching.

5. The method of claim 4, wherein adding the additional metal layer to the RFIC comprises depositing the additional metal layer on the dielectric layer after removing at least the portion of the dielectric layer corresponding to the exposed area of the passivation layer.

6. The method of claim 5, further comprising depositing an additional dielectric layer on the dielectric layer, wherein the additional dielectric layer covers the additional metal layer.

7. The method of claim 6, further comprising removing a portion of the additional dielectric layer, wherein removing the portion of the additional dielectric layer exposes a first portion of the additional metal layer, the first portion of the additional metal layer being different from a second portion of the additional metal layer, wherein the second portion of the additional metal layer overlaps with the exposed area of the passivation layer.

8. The method of claim 7, further comprising depositing a conductive structure coupled to the exposed portion of the additional metal layer.

9. The method of claim 8, wherein the conductive structure is a solder ball.

10. The method of claim 1, wherein the one or more passive electrical components comprises a resistor, a capacitor, an inductor, a transmission line, a coplanar stripline, a transformer, or a microstrip line.

11. An apparatus comprising:
an integrated circuit comprising:
a semiconductor substrate;
a metal layer disposed on a surface of the semiconductor substrate; and
a passivation layer disposed on the surface of the semiconductor substrate and configured to prevent physical contact with the semiconductor substrate, wherein the passivation layer includes an exposed area; and
an interposer comprising an additional metal layer, wherein the additional metal layer contacts an exposed portion of the metal layer corresponding to the exposed area of the passivation layer, wherein the additional metal layer includes one or more passive electrical components.

12. The apparatus of claim 11, wherein the interposer comprises a dielectric layer disposed on the surface of the semiconductor substrate.

13. The apparatus of claim 12, wherein the dielectric layer covers the exposed area of the passivation layer, and wherein the additional metal layer contacts the metal layer through the exposed area of the passivation layer.

14. The apparatus of claim 12, wherein the interposer further comprises an additional dielectric layer disposed on the dielectric layer.

15. The apparatus of claim 14, wherein the interposer further comprises a conductive structure coupled with the additional metal layer through an opening in the additional dielectric layer.

16. The apparatus of claim 15, wherein the conductive structure is a solder ball.

17. The apparatus of claim 11, wherein the one or more passive electrical components comprises a resistor, a capacitor, an inductor, a transmission line, a coplanar stripline, or a microstrip line.
